# EUROPEAN PATENT APPLICATION

(11) **EP 2 518 757 A1**
(43) Date of publication of application: **31.10.2012**
(21) Application number: 10839034.5
(22) Date of filing: 28.09.2010
(51) Int. Cl.: H01L 21/02, C30B 29/36, H01L 21/336, H01L 29/12, H01L 29/78

(54) **SILICON CARBIDE SUBSTRATE**

(30) Priority: 25.12.2009 JP 2009295212
(71) Applicant: Sumitomo Electric Industries, Ltd., Chuo-ku Osaka-shi Osaka 541-0041 (JP)
(72) Inventor: INOUE, Hiroki, Itami-shi Hyogo 664-0016 (JP); HARADA, Shin, Osaka-shi Osaka 554-0024 (JP); SASAKI, Makoto, Itami-shi Hyogo 664-0016 (JP); NISHIGUCHI, Taro, Itami-shi Hyogo 664-0016 (JP); OKITA, Kyoko, Itami-shi Hyogo 664-0016 (JP); NAMIKAWA, Yasuo, Itami-shi Hyogo 664-0016 (JP)
(74) Representative: Grünecker, Kinkeldey, Stockmair & Schwanhäusser
(86) International application number: PCT/JP2010/066765
(87) International publication number: WO 2011/077797

(57) **Abstract**

A silicon carbide substrate (1), which achieves restrained warpage even when a different-type material layer made of a material other than silicon carbide, includes: a base layer (10) made of silicon carbide; and a plurality of SiC layers (20) arranged side by side on the base layer (10) when viewed in a planar view and each made of single-crystal silicon carbide. A gap (60) is formed between end surfaces (20B) of adjacent SiC layers (20).

## Description

### TECHNICAL FIELD

The present invention relates to a silicon carbide substrate, more particularly, a silicon carbide substrate achieving restraint of warpage occurring in a process of manufacturing a semiconductor device.

### BACKGROUND ART

In recent years, in order to achieve high breakdown voltage, low loss, and utilization of semiconductor devices under a high temperature environment, silicon carbide (SiC) has begun to be adopted as a material for a semiconductor device. Silicon carbide is a wide band gap semiconductor having a band gap larger than that of silicon, which has been conventionally widely used as a material for semiconductor devices. Hence, by adopting silicon carbide as a material for a semiconductor device, the semiconductor device can have a high breakdown voltage, reduced on-resistance, and the like. Further, the semiconductor device thus adopting silicon carbide as its material has characteristics less deteriorated even under a high temperature environment than those of a semiconductor device adopting silicon as its material, advantageously.

Such a semiconductor device employing silicon carbide as its material can be fabricated by forming an active layer, an electrode, and the like on a silicon carbide substrate. A process of manufacturing such a semiconductor device includes an exposure step which utilizes a stepper or the like. In the exposure step, if the silicon carbide substrate has warpage, the warpage is reduced by means of a method such as vacuum chuck so as to prevent occurrence of exposure failure.

However, when the warpage of the silicon carbide substrate is large, the warpage cannot be reduced sufficiently using a fixing method such as the above-described vacuum chuck. Accordingly, exposure failure takes place, disadvantageously. To address this, studies have been conducted to reduce the warpage of the silicon carbide substrate. Proposals for the reduction thereof have been presented (for example, see US Patent Application Publication No. 2006/0225645 (Patent Literature 1)).

### CITATION LIST

### PATENT LITERATURE

PTL 1: US Patent Application Publication No. 2006/0225645

### SUMMARY OF INVENTION

### TECHNICAL PROBLEM

According to Patent Literature 1 described above, the warpage and the like of the silicon carbide substrate are reduced to low levels. However, a process of manufacturing a semiconductor device includes a step of forming, on a silicon carbide substrate, a layer (hereinafter, referred to as "different-type material layer") made of a material other than silicon carbide. Conventional silicon carbide substrates including the silicon carbide substrate of Patent Literature 1 will have a large warpage when such a different-type material layer is formed on the silicon carbide substrate, disadvantageously.

In view of the above, the present invention has its object to provide a silicon carbide substrate achieving restrained warpage even when a different-type material layer is formed on the silicon carbide substrate.

### SOLUTION TO PROBLEM

A silicon carbide substrate according to the present invention includes: a base layer made of silicon carbide; and a plurality of SiC layers arranged side by side on the base layer when viewed in a planar view and each made of single-crystal silicon carbide. A gap is formed between adjacent SiC layers.

The present inventor has studied approaches for reducing warpage of a silicon carbide substrate when forming a different-type material layer on the substrate. As a result, the present inventor has found that the warpage can be reduced even when a different-type material layer is formed on a plurality of SiC layers which are made of single-crystal silicon carbide and are arranged side by side on a base layer made of silicon carbide. Specifically, the warpage can be reduced by forming a gap between the SiC layers to provide a buffering effect. Accordingly, according to the silicon carbide substrate of the present invention, the warpage can be restrained even when the different-type material layer is formed on the silicon carbide substrate.

In the silicon carbide substrate, the gap can have a width equal to or smaller than 1 mm. In a process of manufacturing a semiconductor device, the gap needs to be filled with some material before completion of the semiconductor device. If the gap has a width exceeding 1 mm, it becomes difficult to fill the gap in the process of manufacturing the semiconductor device. Hence, the gap is preferably equal to or smaller than 1 mm.

In the silicon carbide substrate, the gap can have a depth equal to or smaller than 2/3 of a thickness of the silicon carbide substrate. If the depth of the gap exceeds 2/3 of the thickness of the substrate, the hardness of the base layer becomes insufficient, which makes it difficult to handle the silicon carbide substrate. Hence, it is preferable that the depth of the gap is equal to or smaller than 2/3 of the thickness of the silicon carbide substrate.

In the silicon carbide substrate, a plurality of the gaps may be formed. Accordingly, the gaps provide a greater buffering effect, thereby restraining warpage more securely.

In the silicon carbide substrate, the plurality of gaps may include at least one pair of gaps extending without intersecting with each other. In this case, an interval between the one pair of gaps is preferably 5 mm or greater.

In the silicon carbide substrate, an active layer, an electrode, and the like are formed on the SiC layers made of single-crystal silicon carbide, thereby fabricating semiconductor devices arranged side by side when viewed in a planar view. Hence, if the interval between the gaps is small, it is difficult to fabricate semiconductor devices efficiently. To address this, with the interval between the gaps being set 5 mm or greater, there can be provided a silicon carbide substrate by which semiconductor devices can be fabricated efficiently.

In the silicon carbide substrate, the plurality of gaps may include at least one pair of gaps intersecting with each other. Accordingly, a silicon carbide substrate can be provided which can reduce warpage in a plurality of directions.

In the silicon carbide substrate, the plurality of gaps may be formed to intersect with one another in a form of lattice when viewed in a planar view. In this way, the SiC layers can be efficiently disposed on the base layer. As a result, there can be provided a silicon carbide substrate by which semiconductor devices can be fabricated efficiently.

In the silicon carbide substrate, the base layer may have an impurity density greater than that of each of the SiC layers. As described above, in the silicon carbide substrate, the active layer and the like are formed on the SiC layers, thereby fabricating a semiconductor device. Hence, even when defect density, etc., in the base layer is increased by increasing the impurity density of the base layer, there is no direct influence over the characteristics of the semiconductor device. Meanwhile, with the increased impurity density of the base layer, resistivity can be reduced in the base layer. Accordingly, resistivity is reduced in the thickness direction of the silicon carbide substrate. As a result, there can be provided a silicon carbide substrate suitable for fabrication of a vertical type semiconductor device in which a current flows in the thickness direction of the silicon carbide substrate.

In the silicon carbide substrate, the base layer can have an impurity density equal to or greater than 1 × 10¹⁸ atm/cm³. Accordingly, resistivity is reduced in the thickness direction of the silicon carbide substrate, thereby providing a silicon carbide substrate suitable for fabrication of a vertical type semiconductor device. For further reduction of the resistivity in the thickness direction of the silicon carbide substrate, the impurity density of the base layer may be set at 1 × 10²⁰ atm/cm³ or greater.

In the silicon carbide substrate, each of the SiC layers may have a main surface opposite to the base layer and having an off angle of not less than 50° and not more than 65 relative to a {0001} plane.

By growing single-crystal silicon carbide of hexagonal system in the <0001> direction, a high-quality single-crystal can be fabricated efficiently. From such a silicon carbide single-crystal grown in the <0001> direction, a silicon carbide substrate having a main surface corresponding to the {0001} plane can be obtained efficiently. Meanwhile, by using a silicon carbide substrate having a main surface having an off angle of not less than 50° and not more than 65° relative to the plane orientation of {0001}, a semiconductor device with high performance may be manufactured.

Specifically, for example, it is general that a silicon carbide substrate used in fabricating a MOSFET (Metal Oxide Semiconductor Field Effect Transistor; Metal-Oxide Film-Semiconductor Field Effect Transistor) has a main surface having an off angle of approximately 8° relative to the plane orientation of {0001}. An epitaxial growth layer is formed on this main surface and an oxide film, an electrode, and the like are formed on this epitaxial growth layer, thereby obtaining a MOSFET. In this MOSFET, a channel region is formed in a region including an interface between the epitaxial growth layer and the oxide film. However, in the MOSFET having such a structure, a multiplicity of interface states are formed around the interface between the epitaxial growth layer and the oxide film, i.e., the location in which the channel region is formed, due to the substrate's main surface having an off angle of approximately 8° relative to the plane orientation of {0001}. This hinders traveling of carriers, thus decreasing channel mobility.

To address this, in the silicon carbide substrate, the main surface of the SiC layer opposite to the base layer is adapted to have an off angle of not less than 50° and not more than 65° relative to the {0001} plane, thereby reducing formation of the interface states. In this way, a MOSFET can be fabricated which allows for reduced on-resistance.

In the silicon carbide substrate, the main surface of each of the SiC layers opposite to the base layer may have an off orientation forming an angle of 5° or smaller relative to a <1-100> direction.

The <1-100> direction is a representative off orientation in a silicon carbide substrate. Variation in the off orientation resulting from variation in a slicing process of the process of manufacturing the substrate is adapted to be 5° or smaller, which allows an epitaxial growth layer to be formed readily on the silicon carbide substrate.

In the silicon carbide substrate, the main surface of each of the SiC layers opposite to the base layer may have an off angle of not less than -3° and not more than 5° relative to a {03-38} plane in the <1-100> direction.

Accordingly, channel mobility can be further improved in the case where a MOSFET is fabricated using the silicon carbide substrate. Here, setting the off angle at not less than -3° and not more than +5° relative to the plane orientation of {03-38} is based on a fact that particularly high channel mobility was obtained in this set range as a result of inspecting a relation between the channel mobility and the off angle.

Further, the "off angle relative to the {03-38} plane in the <1-100> direction" refers to an angle formed by an orthogonal projection of a normal line of the above-described main surface to a flat plane defined by the <1-100> direction and the <0001> direction, and a normal line of the {03-38} plane. The sign of positive value corresponds to a case where the orthogonal projection approaches in parallel with the <1-100> direction whereas the sign of negative value corresponds to a case where the orthogonal projection approaches in parallel with the <0001> direction.

It should be noted that the main surface preferably has a plane orientation of substantially {03-38}, and the main surface more preferably has a plane orientation of {03-38}. Here, the expression "the main surface has a plane orientation of substantially {03-38}" is intended to encompass a case where the plane orientation of the main surface of the substrate is included in a range of off angle such that the plane orientation can be substantially regarded as {03-38} in consideration of processing accuracy of the substrate. In this case, the range of off angle is, for example, a range of off angle of ±2° relative to {03-38}. Accordingly, the above-described channel mobility can be further improved.

In the silicon carbide substrate, the main surface of each of the SiC layers opposite to the base layer may have an off orientation forming an angle of 5° or smaller relative to a <111-20> direction.

<11-20> is a representative off orientation in a silicon carbide substrate, as with the <1-100> direction. Variation in the off orientation resulting from variation in the slicing process of the process of manufacturing the substrate is adapted to be ±5°, which allows an epitaxial growth layer to be formed readily on the SiC substrate.

In the silicon carbide substrate, a main surface of each of the SiC layers opposite to the base layer may be polished. This allows a high-quality epitaxial growth layer to be formed on the main surface of each of the SiC layers opposite to the base layer. As a result, a semiconductor device can be manufactured which includes the high-quality epitaxial growth layer as an active layer, for example. Namely, by employing such a structure, the silicon carbide substrate can be obtained which allows for manufacturing of a high-quality semiconductor device including the epitaxial layer formed on the SiC layers.

### ADVANTAGEOUS EFFECTS OF INVENTION

As apparent from the description above, according to the silicon carbide substrate of the present invention, there can be provided a silicon carbide substrate achieving restrained warpage even when a different-type material layer is formed on the silicon carbide substrate.

### BRIEF DESCRIPTION OF DRAWINGS

Fig. 1 is a schematic cross sectional view showing a structure of a silicon carbide substrate.
Fig. 2 is a schematic planar view showing the structure of the silicon carbide substrate.
Fig. 3 is a flowchart schematically showing a method for manufacturing the silicon carbide substrate.
Fig. 4 is a flowchart schematically showing a method for manufacturing the silicon carbide substrate in the second embodiment.
Fig. 5 is a schematic cross sectional view for illustrating the method for manufacturing the silicon carbide substrate.
Fig. 6 is a schematic cross sectional view for illustrating the method for manufacturing the silicon carbide substrate.
Fig. 7 is a schematic cross sectional view for illustrating the method for manufacturing the silicon carbide substrate.
Fig. 8 is a schematic cross sectional view showing a structure of a silicon carbide substrate in a third embodiment.
Fig. 9 is a flowchart schematically showing a method for manufacturing the silicon carbide substrate in the third embodiment.
Fig. 10 is a schematic cross sectional view for illustrating the method for manufacturing the silicon carbide substrate.
Fig. 11 is a schematic cross sectional view showing a structure of a silicon carbide substrate in a fourth embodiment.
Fig. 12 is a flowchart schematically showing a method for manufacturing the silicon carbide substrate in the fourth embodiment.
Fig. 13 is a schematic cross sectional view for illustrating the method for manufacturing the silicon carbide substrate.
Fig. 14 is a schematic cross sectional view showing a structure of a vertical type MOSFET.
Fig. 15 is a flowchart schematically showing a method for manufacturing the vertical type MOSFET.
Fig. 16 is a schematic cross sectional view for illustrating the method for manufacturing the vertical type MOSFET.
Fig. 17 is a schematic cross sectional view for illustrating the method for manufacturing the vertical type MOSFET.
Fig. 18 is a schematic cross sectional view for illustrating the method for manufacturing the vertical type MOSFET.
Fig. 19 is a schematic cross sectional view for illustrating the method for manufacturing the vertical type MOSFET.
Fig. 20 is a schematic view for illustrating a definition of warpage (SORI).

### DESCRIPTION OF EMBODIMENTS

The following describes embodiments of the present invention with reference to figures. It should be noted that in the below-mentioned figures, the same or corresponding portions are given the same reference characters and are not described repeatedly.

### (First Embodiment)

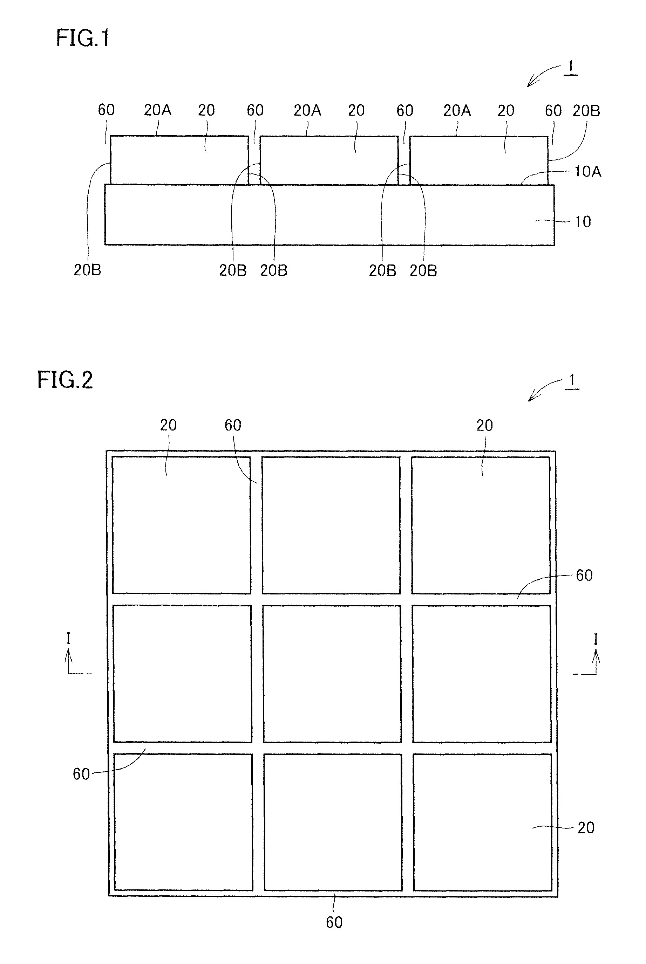

First, one embodiment, i.e., a first embodiment of the present invention will be described with reference to Fig. 1 and Fig. 2. Fig. 1 corresponds to a cross sectional view taken along a line I-I in Fig. 2. Referring to Fig. 1 and Fig. 2, silicon carbide substrate 1 in the present embodiment includes: a base layer 10 made of silicon carbide; and a plurality of SiC layers 20 arranged side by side on base layer 10 when viewed in a planar view and made of single-crystal silicon carbide. In other words, the plurality of SiC layers 20 are arranged along a main surface 10A of base layer 10. Between end surfaces 20B of adjacent SiC layers 20, a gap 60 is formed.

In silicon carbide substrate 1 of the present embodiment, gap 60 is thus formed between SiC layers 20. Accordingly, even when a different-type material layer is formed on SiC layers 20, gap 60 provides a buffering effect to reduce warpage. As a result, silicon carbide substrate 1 becomes a silicon carbide substrate achieving restrained warpage even when a different-type material layer is formed thereon. Further, in order to attain more secure effect of restraining the warpage by forming gap 60, referring to Fig. 2, it is preferable to form gap 60 to extend across silicon carbide substrate 1 from an end portion thereof to the other end portion thereof when viewed in a planar view.

Here, gap 60 has a width that can be selected at an any value. However, by setting the width of gap 60 at 1 mm or smaller, gap 60 can be filled readily in the case where gap 60 needs to be filled with some material before completion of a semiconductor device. Further, gap 60 preferably has a width equal to or smaller than 100 µm, more preferably, equal to or smaller than 10 µm.

Further, gap 60 have a depth that can be selected at any value. However, by setting the depth of gap 60 at not more than 2/3 of the thickness of silicon carbide substrate 1, base layer 10 is provided with sufficient hardness. Accordingly, silicon carbide substrate 1 can be handled readily.

Further, one gap 60 may be provided but it is preferable to form a plurality of gaps 60. Gaps 60 thus formed provide a greater buffering effect, thereby more securely restraining warpage of silicon carbide substrate 1.

Further, in the case where the plurality of gaps 60 are formed, gaps 60 can be arranged appropriately but may include at least one pair of gaps 60 extending without intersecting with each other. On this occasion, an interval between the pair of gaps 60 is preferably equal to or greater than 5 mm. In this way, in manufacturing semiconductor devices using silicon carbide substrate 1, efficiency of manufacturing of the semiconductor devices is prevented from being decreased due to the formation of gaps 60.

Further, in the case where the plurality of gaps 60 are formed, the plurality of gaps 60 preferably include at least one pair of gaps 60 intersecting with each other. Accordingly, warpage in a plurality of directions can be reduced. On this occasion, the pair of gaps 60 are adapted to linearly extend across silicon carbide substrate 1 from one end to the other end when viewed in a planar view, whereby the warpage can be reduced more securely.

Further, in the case where the plurality of gaps 60 are formed, the plurality of gaps 60 are preferably formed to intersect with one another in the form of a lattice when viewed in a planar view as shown in Fig. 1 and Fig. 2. This allows SiC layers 20 to be disposed efficiently on base layer 10, thereby improving efficiency in fabricating semiconductor devices using silicon carbide substrate 1.

Further, in silicon carbide substrate 1 the value of impurity density in each of base layer 10 and SiC layer 20 can be appropriately selected depending on a purpose of use, etc., of silicon carbide substrate 1. For example, base layer 10 can have an impurity density greater than that of SiC layer 20. In this way, on-resistance of a semiconductor device can be reduced in the case where silicon carbide substrate 1 is used to fabricate a vertical type semiconductor device in which a current flows in the thickness direction of silicon carbide substrate 1. More specifically, base layer 10 can have an impurity density of 1 × 10¹⁸ atm/cm³ or greater, and may have an impurity density of 1 × 10²⁰ atm/cm³ or greater.

Further, in silicon carbide substrate 1 described above, main surface 20A of each of SiC layers 20 opposite to base layer 10 may have an off angle of not less than 50° and not more than 65° relative to the {0001} plane. By fabricating a MOSFET using such a silicon carbide substrate 1, formation of interface states can be reduced in a channel region, thereby obtaining a MOSFET reduced in on-resistance. Meanwhile, in order to facilitate the manufacturing, main surface 20A of SiC layer 20 may correspond to the {0001} plane.

Further, the off orientation of main surface 20A of SiC layer 20 may form an angle of 5° or less relative to the <1-100> direction. The <1-100> direction is a representative off orientation in a silicon carbide substrate. Variation in the off orientation resulting from variation in a slicing process of the process of manufacturing the substrate is adapted to be 5° or smaller, which allows an epitaxial growth layer to be formed readily on silicon carbide substrate 1.

Further, in silicon carbide substrate 1, main surface 20A of SiC layer 20 preferably has an off angle of not less than -3° and not more than 5° relative to the {03-38} plane in the <1-100> direction. Accordingly, channel mobility can be further improved in the case where a MOSFET is fabricated using silicon carbide substrate 1.

Further, in silicon carbide substrate 1, the off orientation of main surface 20A of SiC layer 20 may form an angle of 5° or smaller relative to the <11-20> direction.

<11-20> is also a representative off orientation in a silicon carbide substrate. Variation in the off orientation resulting from variation in a slicing process of the process of manufacturing the substrate is adapted to be ±5°, which allows an epitaxial growth layer to be formed readily on silicon carbide substrate 1.

Further, in silicon carbide substrate 1 of the present embodiment, main surface 20A of SiC layer 20 is preferably polished. This allows for formation of a high-quality epitaxial growth layer on main surface 20A. As a result, a semiconductor device can be manufactured which includes the high-quality epitaxial growth layer as an active layer, for example. Namely, by employing such a structure, silicon carbide substrate 1 can be obtained which allows for manufacturing of a high-quality semiconductor device including the epitaxial layer formed on SiC layer 20.

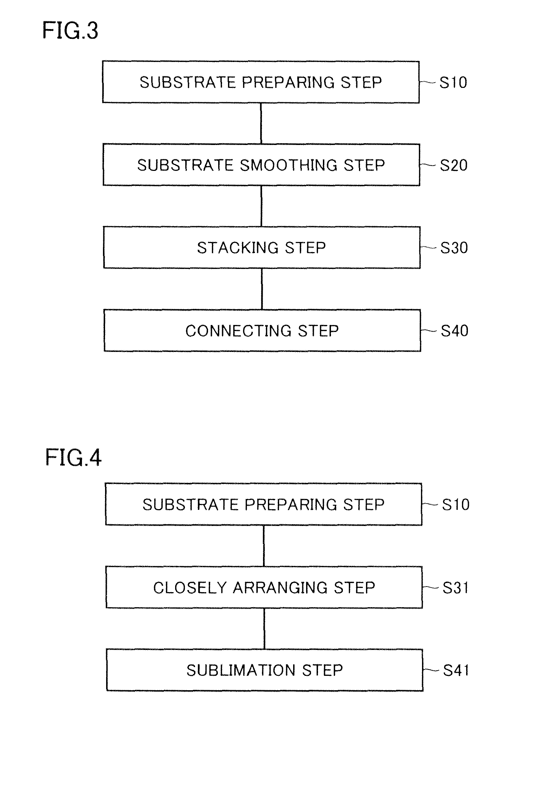

The following describes an exemplary method for manufacturing silicon carbide substrate 1 described above. Referring to Fig. 3, in the method for manufacturing the silicon carbide substrate in the present embodiment, first, as a step (S10), a substrate preparing step is performed. In this step (S 10), referring to Fig. 1 and Fig. 2, a base substrate 10 and SiC substrates 20, both of which are made of single-crystal silicon carbide, are prepared. Each of SiC substrates 20 has a main surface, which will be main surface 20A of SiC layer 20 that will be obtained by this manufacturing method (see Fig. 1). Hence, on this occasion, the plane orientation of the main surface of SiC substrate 20 is selected in accordance with a desired plane orientation of main surface 20A. Here, for example, SiC substrates 20 each having a main surface corresponding to the {03-38} plane is prepared. Meanwhile, a substrate having an impurity density greater than, for example, 2 × 10¹⁹ cm⁻³ is adopted as base substrate 10. Meanwhile, for each of SiC substrates 20, a substrate having an impurity density smaller than that of base substrate 10 is employed.

Next, a substrate smoothing step is performed as a step (S20) when required. In this step (S20), the main surface of base substrate 10 and the main surface of SiC substrate 20 (connection surface) are smoothed by, for example, polishing. The main surfaces are to be brought into contact with each other in a below-described step (S30). This step (S20) is not an essential step, but provides, if performed, a gap having a uniform size between base substrate 10 and SiC substrate 20, which are to face each other. Accordingly, in a below-described step (S40), uniformity is improved in reaction (connection) at the connection surface. This allows base substrate 10 and SiC substrate 20 to be connected to each other more securely.

Meanwhile, step (S20) may be omitted, i.e., step (S30) may be performed without polishing the main surfaces of base substrate 10 and SiC substrate 20, which are to be brought into contact with each other. This reduces manufacturing cost of silicon carbide substrate 1. Further, for removal of damaged layers located in surfaces formed by slicing upon fabrication of base substrate 10 and SiC substrate 20, a step of removing the damaged layers may be performed by, for example, etching instead of step (S20) or after step (S20), and then step (S30) described below may be performed.

Next, a stacking step is performed as step (S30). In this step (S30), the plurality of SiC substrates 20 are placed on and in contact with main surface 10A of base substrate 10, thereby fabricating a stacked substrate. On this occasion, the plurality of SiC substrates 20 are arranged side by side with gap 60 being formed between end surfaces 20B of adjacent SiC substrates 20 as shown in Fig. 1 and Fig. 2, when viewed in a planar view. More specifically, the plurality of SiC substrates 20 are arranged in the form of a matrix on base layer 10 such that gap 60 is formed between adjacent SiC layers 20.

Next, as step (S40), a connecting step is performed. In step (S40), base substrate 10 and each of SiC substrates 20 are connected to each other by heating the stacked substrate. With the process above, silicon carbide substrate 1 of the first embodiment can be manufactured readily, which includes base substrate 10 as base layer 10, and the plurality of SiC substrates 20 connected to base layer 10 as SiC layers 20, wherein gap 60 is formed between adjacent SiC layers 20.

Here, in step (S40), it is preferable to heat the stacked substrate to fall within a range of temperature equal to or higher than the sublimation temperature of silicon carbide. This allows base substrate 10 and SiC substrate 20 to be connected to each other more securely. In particular, with the gap of 100 µm or smaller being formed between base substrate 10 and SiC substrate 20 in the stacked substrate, uniform connection can be achieved by sublimation of SiC. Further, by heating to the temperature equal to or greater than the sublimation temperature, base substrate 10 and SiC substrate 20 can be connected to each other readily even in the case where step (S20) is not performed and step (S30) is performed without polishing the main surfaces of base substrate 10 and SiC substrate 20 which are to be brought into contact with each other. It should be noted that in this step (S40), the stacked substrate may be heated in an atmosphere obtained by reducing pressure of the atmospheric air. This reduces manufacturing cost of silicon carbide substrate 1.

Further, heating temperature for the stacked substrate in step (S40) is preferably not less than 1800°C and not more than 2500°C. If the heating temperature is lower than 1800°C, it takes a long time to connect base substrate 10 and SiC substrate 20, which results in decreased efficiency in manufacturing silicon carbide substrate 1. On the other hand, if the heating temperature exceeds 2500°C, surfaces of base substrate 10 and SiC substrate 20 become rough, which may result in generation of a multiplicity of crystal defects in silicon carbide substrate 1 to be fabricated. Further, in step (S40), pressure in atmosphere during heating is set at not less than 10⁻⁵ Pa and not more than 10⁶ Pa. Hence, a simple device can be used to achieve the connection. Further, the stacked substrate may be heated under a pressure higher than 10⁻¹ Pa and lower than 10⁴ Pa. This can accomplish the above-described connection using a simpler device, and provide an atmosphere for accomplishing the connection for a relatively short time, thereby achieving reduced manufacturing cost of silicon carbide substrate 1. Further, the atmosphere upon the heating in step (S40) may be inert gas atmosphere. In the case where the atmosphere is the inert gas atmosphere, the inert gas atmosphere preferably contains at least one selected from a group consisting of argon, helium, and nitrogen.

Further, the above-described method for manufacturing silicon carbide substrate 1 in the present embodiment may further include a step of polishing the main surface of SiC substrate 20 that corresponds to main surface 20A of SiC substrate 20 opposite to base substrate 10 in the stacked substrate. Accordingly, a silicon carbide substrate 1 is manufactured in which main surface 20A of SiC layer 20 opposite to base layer 10 has been polished. Here, the step of polishing may be performed before or after connecting base substrate 10 and SiC substrate 20 to each other, as long as the step of polishing is performed after step (S10).

### (Second Embodiment)

The following describes another embodiment of the present invention, i.e., a second embodiment. Referring to Fig. 1, a silicon carbide substrate 1 in the second embodiment has basically the same structure and provides basically the same effects as those of silicon carbide substrate 1 in the first embodiment. However, silicon carbide substrate 1 in the second embodiment is different from that of the first embodiment in terms of a manufacturing method.

Referring to Fig. 4, a substrate preparing step is first performed as a step (S 10) in the method for manufacturing silicon carbide substrate 1 in the second embodiment. In step (S10), SiC substrates are prepared as with the first embodiment, and a material substrate made of silicon carbide is prepared.

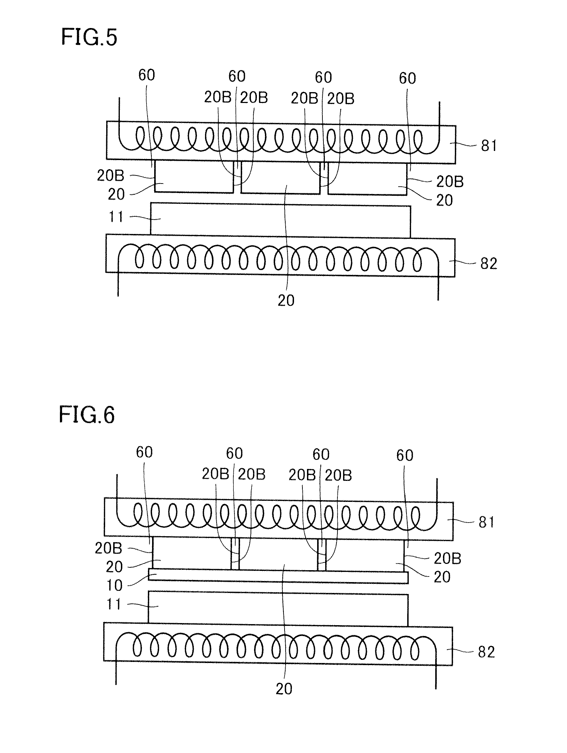

Next, referring to Fig. 4, a closely arranging step is performed as a step (S31). In this step (S31), referring to Fig. 5, the plurality of SiC substrates 20 and a material substrate 11 are held by first heater 81 and second heater 82 disposed face to face with each other. On this occasion, SiC substrates 20 and material substrate 11 are arranged such that their main surfaces are disposed close to and face to face with one another with an interval of not less than 1 µm and not more than 1 cm, for example, approximately 1 mm therebetween. Here, an appropriate value of the interval between SiC substrate 20 and material substrate 11 is considered to be associated with a mean free path for a sublimation gas obtained upon heating in a below-described step (S41). Specifically, the average value of the interval between each SiC substrate 20 and material substrate 11 can be set to be smaller than the mean free path for the sublimation gas obtained upon heating in the below-described step (S41). For example, strictly, a mean free path for atoms and molecules depends on atomic radius and molecule radius at a pressure of 1 Pa and a temperature of 2000°C, but is approximately several cm to several ten cm. Hence, realistically, the interval is preferably set at several cm or smaller. More specifically, SiC substrate 20 and material substrate 11 are arranged close to each other such that their main surfaces face each other with an interval of not less than 1 µm and not more than 1 cm therebetween. With the average value of the interval being 1 cm or smaller, distribution in film thickness of base layer 10 to be formed in the below-described step (S41) can be reduced further. Further, with the average value of the interval being 1 mm or smaller, the distribution in film thickness of base layer 10 to be formed in the below-described step (S41) can be reduced further. Meanwhile, with the average value of the interval being 1 µm or greater, there can be secured a sufficient interval for sublimation of silicon carbide. It should be noted that this sublimation gas is a gas formed by sublimation of solid silicon carbide, and includes Si, Si₂C, and SiC₂, for example. Further, between end surfaces 20B of SiC substrates 20, gap 60 of a predetermined width is formed.

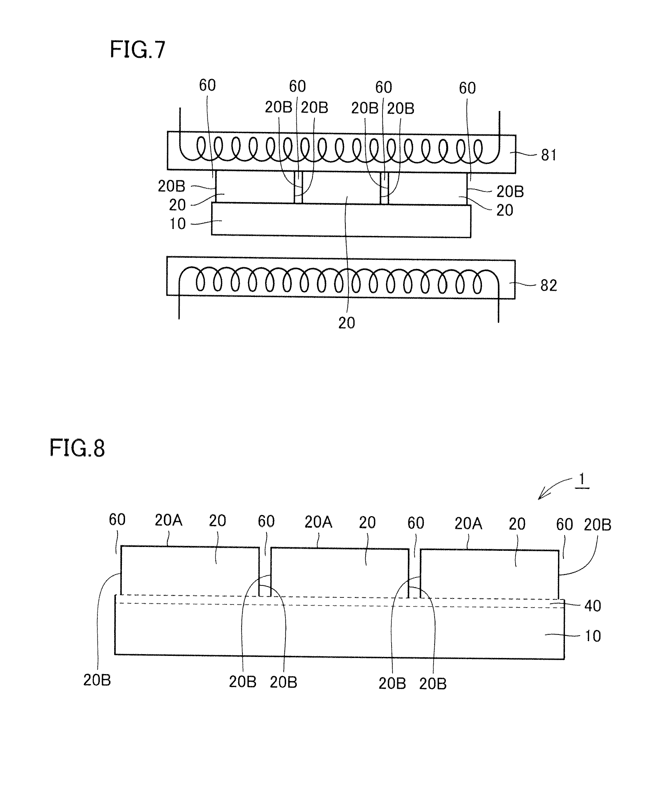

Next, as step (S41), a sublimation step is performed. In this step (S41), each of SiC substrates 20 is heated to a predetermined substrate temperature by first heater 81. Further, material substrate 11 is heated to a predetermined material temperature by second heater 82. On this occasion, material substrate 11 is heated to reach the material temperature, thereby sublimating SiC (silicon carbide) from the surface of the material substrate. On the other hand, the substrate temperature is set lower than the material temperature. Specifically, for example, the substrate temperature is set lower than the material temperature by not less than 1°C and not more than 100°C. The substrate temperature is preferably 1800°C or greater and 2500°C or smaller. Accordingly, as shown in Fig. 6, SiC sublimated from material substrate 11 in the form of gas reaches the surface of SiC substrate 20 and is accordingly solidified thereon, thereby forming base layer 10. With this state being maintained, as shown in Fig. 7, all the SiC constituting material substrate 11 is sublimated and is transferred onto the surface of SiC substrate 20. Accordingly, step (S41) is completed, thereby completing silicon carbide substrate 1 shown in Fig. 1 and Fig. 2.

### (Third Embodiment)

The following describes still another embodiment of the present invention, i.e., a third embodiment. Referring to Fig. 8, a silicon carbide substrate 1 in the third embodiment has basically the same configuration and provides basically the same effects as those of silicon carbide substrate 1 in the first embodiment. However, silicon carbide substrate 1 in the third embodiment is different from that of the first embodiment in that an amorphous SiC layer 40 serving as an intermediate layer is provided between base layer 10 and each of SiC layers 20.

Namely, in silicon carbide substrate 1 in the third embodiment, amorphous SiC layer 40 is disposed between base layer 10 and SiC layer 20 as an intermediate layer made of amorphous SiC. Then, base layer 10 and SiC layer 20 are connected to each other by this amorphous SiC layer 40. Amorphous SiC layer 40 thus existing readily provides silicon carbide substrate 1 in which base layer 10 and the plurality of SiC layers 20 arranged side by side when viewed in a planar view are stacked on each other.

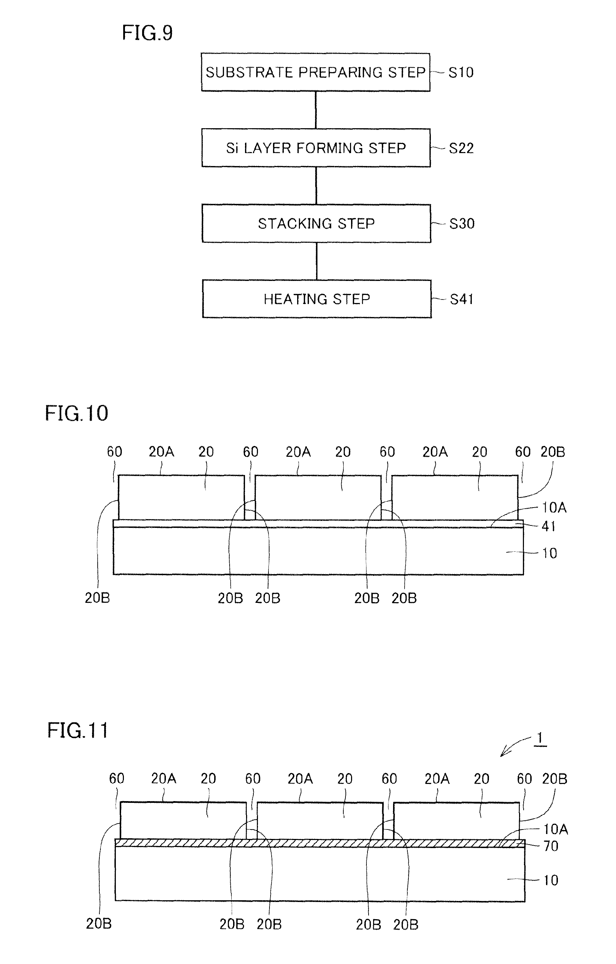

The following describes a method for manufacturing silicon carbide substrate 1 in the third embodiment. Referring to Fig. 9, in the method for manufacturing silicon carbide substrate 1 in the third embodiment, the substrate preparing step is performed as step (S10) in the same way as in the first embodiment, so as to prepare base substrate 10 and the plurality of SiC substrates 20.

Next, a Si layer forming step is performed as a step (S22). In this step (S22), referring to Fig. 10, a Si layer 41 having a thickness of approximately 100 nm is formed on one main surface 10A of base substrate 10 prepared in step (S10), for example. This Si layer 41 can be formed using the sputtering method, for example.

Next, a stacking step is performed as step (S30). In this step (S30), the plurality of SiC substrates 20 prepared in step (S10) are arranged side by side on Si layer 41 formed in step (S22) when viewed in a planar view such that there is a gap 60 between end surfaces 20B of the plurality of SiC substrates 20. In this way, a stacked substrate is obtained in which the plurality of SiC substrates 20 are provided over base substrate 10 with Si layer 41 interposed therebetween.

Next, as a step (S41), a heating step is performed. In this step (S41), the stacked substrate fabricated in step (S30) is heated, for example, in a mixed gas atmosphere of hydrogen gas and propane gas under a pressure of 1 × 10³ Pa at approximately 1500°C for 3 hours. Accordingly, Si layer 41 is supplied with carbon as a result of diffusion mainly from base substrate 10 and SiC substrates 20, thereby forming amorphous SiC layer 40 as shown in Fig. 8. In this way, silicon carbide substrate 1 of the third embodiment can be readily manufactured, in which base layer 10 is connected by amorphous SiC layer 40 to SiC layers 20, which are arranged side by side with gap 60 between end surfaces 20B when viewed in a planar view.

### (Fourth Embodiment)

The following describes yet another embodiment of the present invention, i.e., a fourth embodiment. Referring to Fig. 11, a silicon carbide substrate 1 in the fourth embodiment has basically the same configuration and provides basically the same effects as those of silicon carbide substrate 1 in the first embodiment. However, silicon carbide substrate 1 in the fourth embodiment is different from that of the first embodiment in that an intermediate layer 70 is formed between base layer 10 and each of SiC layers 20.

More specifically, intermediate layer 70 contains carbon to serve as a conductor. Here, intermediate layer 70 usable herein contains, for example, graphite particles and non-graphitizable carbon. Preferably, intermediate layer 70 has a carbon composite structure including graphite particles and non-graphitizable carbon.

In other words, in silicon carbide substrate 1 in the fourth embodiment, intermediate layer 70 containing carbon and therefore serving as a conductor is disposed between base layer 10 and each of the plurality of SiC layers 20, which are arranged side by side with adjacent end surfaces 20B forming gap 60 when viewed in a planar view. Further, base layer 10 and SiC layer 20 are connected to each other by this intermediate layer 70. Intermediate layer 70 thus existing facilitates fabrication of silicon carbide substrate 1 in which base layer 10 and SiC layer 20 are stacked on each other.

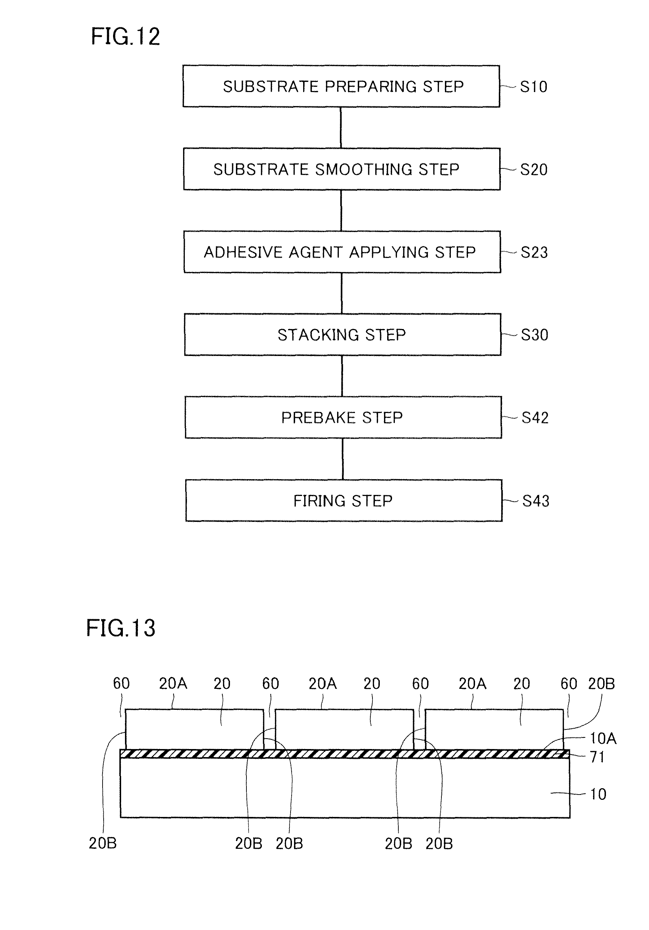

The following describes a method for manufacturing silicon carbide substrate 1 in the fourth embodiment. Referring to Fig. 12, in the method for manufacturing silicon carbide substrate 1 in the fourth embodiment, step (S10) is performed in the same way as in the first embodiment. Then, as required, step (S20) is performed in the same way as in the first embodiment.

Next, as a step (S23), an adhesive agent applying step is performed. In this step (S23), referring to Fig. 13, for example, a carbon adhesive agent is applied to main surface 10A of base substrate 10, thereby forming a precursor layer 71. The carbon adhesive agent can be formed of, for example, a resin, graphite particles, and a solvent. Here, an exemplary resin usable is a resin formed into non-graphitizable carbon by heating, such as a phenol resin. An exemplary solvent usable is phenol, formaldehyde, ethanol, or the like. Further, the carbon adhesive agent is applied at an amount of not less than 10 mg/cm² and not more than 40 mg/cm², more preferably, not less than 20 mg/cm² and not more than 30 mg/cm². Further, the carbon adhesive agent applied preferably has a thickness of not more than 100 µm, more preferably, not more than 50 µm.

Next, a stacking step is performed as step (S30). In this step (S30), referring to Fig. 13, the plurality of SiC substrates 20 are placed in the form of matrix on and in contact with precursor layer 71 formed on and in contact with main surface 10A of base substrate 10, with gap 60 being formed between end surfaces 20B. In this way, a stacked substrate is fabricated.

Next, as a step (S42), a prebake step is performed. In this step (S42), the stacked substrate is heated, thereby removing the solvent component from the carbon adhesive agent constituting precursor layer 71. Specifically, for example, while applying a load to the stacked substrate in the thickness direction thereof, the stacked substrate is gradually heated to fall within a range of temperature exceeding the boiling point of the solvent component. Preferably, this heating is performed with base substrate 10 and SiC substrate 20 being pressed against each other using a clamp or the like. Further, by performing the prebaking (heating) as long as possible, the adhesive agent is degassed to improve strength in adhesion.

Next, as a step (S43), a firing step is performed. In this step (S43), the stacked substrate with precursor layer 71 heated and accordingly prebaked in step (S42) is heated to a high temperature, preferably, not less than 900°C and not more than 1100°C, for example, 1000°C for preferably not less than 10 minutes and not more than 10 hours, for example, for 1 hour, thereby firing precursor layer 71. Atmosphere employed upon the firing can be an inert gas atmosphere such as argon. The pressure of the atmosphere can be, for example, atmospheric pressure. In this way, precursor layer 71 is formed into intermediate layer 70 made of carbon that is a conductor (see Fig. 13 and Fig. 11). With the process above, silicon carbide substrate 1 of the fourth embodiment can be readily manufactured, in which base layer 10 is connected by intermediate layer 70 to SiC layers 20, which are arranged side by side with gap 60 between end surfaces 20B when viewed in a planar view.

It should be noted that the third and fourth embodiments have illustrated the intermediate layers made of amorphous SiC and carbon respectively, but the intermediate layer is not limited to these. Instead of these, an intermediate layer made of a metal can be employed, for example. In this case, as the metal, it is preferable to employ a metal that can make ohmic contact with silicon carbide by forming a silicide, such as nickel.

### (Fifth Embodiment)

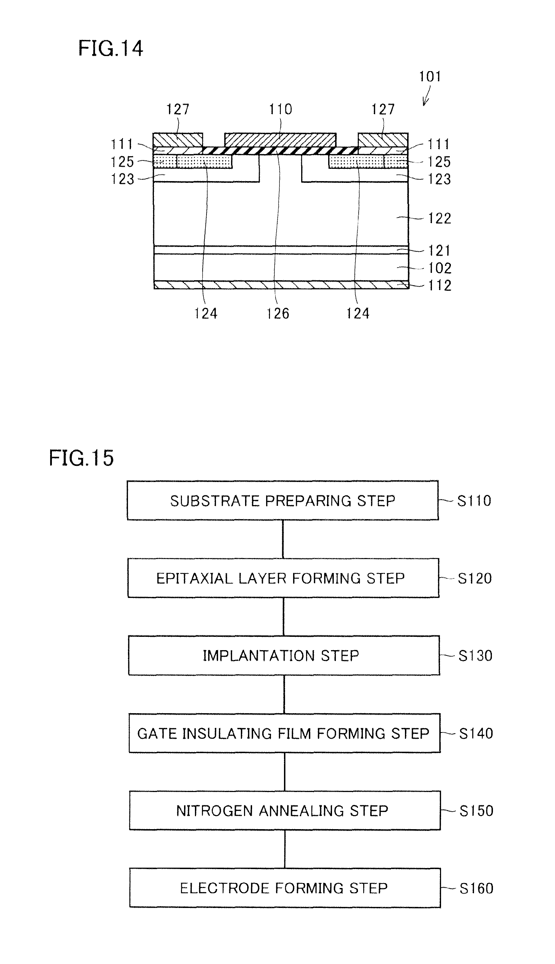

As a fifth embodiment, the following describes one exemplary semiconductor device fabricated using the above-described silicon carbide substrate of the present invention. Referring to Fig. 14, a semiconductor device 101 according to the present invention is a DiMOSFET (Double Implanted MOSFET) of vertical type, and has a substrate 102, a buffer layer 121, a breakdown voltage holding layer 122, p regions 123, n⁺ regions 124, p⁺ regions 125, an oxide film 126, source electrodes 111, upper source electrodes 127, a gate electrode 110, and a drain electrode 112 formed on the backside surface of substrate 102. Specifically, buffer layer 121 made of silicon carbide is formed on the front-side surface of substrate 102 made of silicon carbide of n type conductivity. As substrate 102, there is employed a silicon carbide substrate of the present invention, inclusive of silicon carbide substrate 1 described in each of the first to fourth embodiments. In the case where silicon carbide substrate 1 in each of the first to fourth embodiments is employed, buffer layer 121 is formed on each of SiC layers 20 of silicon carbide substrate 1. Buffer layer 121 has n type conductivity, and has a thickness of, for example, 0.5 µm. Further, impurity with n type conductivity in buffer layer 121 has a concentration of, for example, 5 × 10¹⁷ cm⁻³. Formed on buffer layer 121 is breakdown voltage holding layer 122. Breakdown voltage holding layer 122 is made of silicon carbide of n type conductivity, and has a thickness of 10 µm, for example. Further, breakdown voltage holding layer 122 includes an impurity of n type conductivity at a concentration of, for example, 5 × 10¹⁵ cm⁻³.

Breakdown voltage holding layer 122 has a surface in which p regions 123 of p type conductivity are formed with an interval therebetween. In each of p regions 123, an n⁺ region 124 is formed at the surface layer of p region 123. Further, at a location adjacent to n⁺ region 124, a p⁺ region 125 is formed. Oxide film 126 is formed to extend on n⁺ region 124 in one p region 123, p region 123, an exposed portion of breakdown voltage holding layer 122 between the two p regions 123, the other p region 123, and n⁺ region 124 in the other p region 123. On oxide film 126, gate electrode 110 is formed. Further, source electrodes 111 are formed on n⁺ regions 124 and p⁺ regions 125. On source electrodes 111, upper source electrodes 127 are formed. Moreover, drain electrode 112 is formed on the backside surface of substrate 102, i.e., the surface opposite to its front-side surface on which buffer layer 121 is formed.

Semiconductor device 101 in the present embodiment employs, as substrate 102, the silicon carbide substrate of the present invention, such as silicon carbide substrate 1 described in each of the first to fourth embodiments. Here, as described above, the silicon carbide substrate of the present invention achieves restrained warpage even when a different-type material layer is formed on the silicon carbide substrate. Thus, semiconductor device 101 is stable in its characteristics.

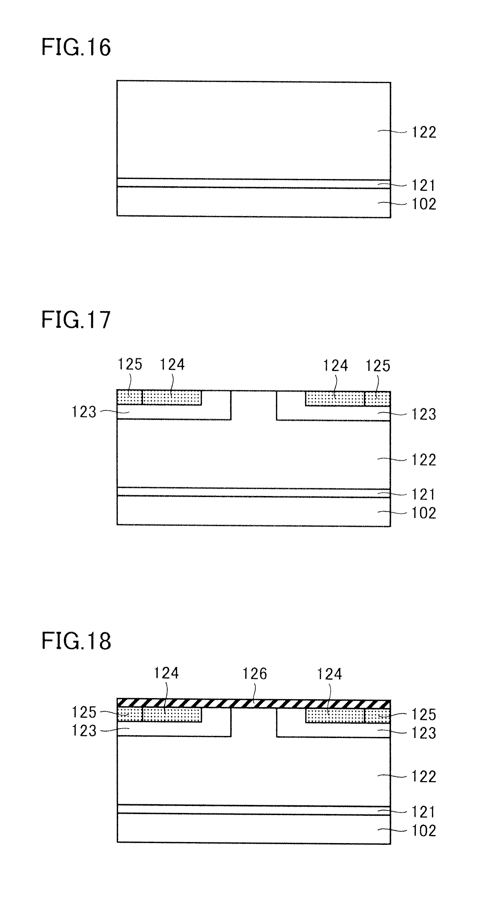

The following describes a method for manufacturing semiconductor device 101 shown in Fig. 14, with reference to Fig. 15-Fig. 19. Referring to Fig. 15, first, a substrate preparing step (S110) is performed. Prepared here is, for example, substrate 102, which is made of silicon carbide and has its main surface corresponding to the (03-38) plane (see Fig. 16). As substrate 102, there is prepared a silicon carbide substrate of the present invention, inclusive of silicon carbide substrate 1 manufactured in accordance with each of the manufacturing methods described in the first to fourth embodiments.

As substrate 102 (see Fig. 16), a substrate may be employed which has n type conductivity and has a substrate resistance of 0.02 Ωcm.

Next, as shown in Fig. 15, an epitaxial layer forming step (S120) is performed. Specifically, buffer layer 121 is formed on the front-side surface of substrate 102. Buffer layer 121 is formed on SiC layers 20 (see Fig. 1, Fig. 8, Fig. 11) of silicon carbide substrate 1 employed as substrate 102. As buffer layer 121, an epitaxial layer is formed which is made of silicon carbide of n type conductivity and has a thickness of 0.5 µm, for example. Buffer layer 121 has a conductive impurity at a concentration of, for example, 5 × 10¹⁷ cm⁻³. Then, on buffer layer 121, breakdown voltage holding layer 122 is formed as shown in Fig. 16. As breakdown voltage holding layer 122, a layer made of silicon carbide of n type conductivity is formed using an epitaxial growth method. Breakdown voltage holding layer 122 can have a thickness of, for example, 10 µm. Further, breakdown voltage holding layer 122 includes an impurity of n type conductivity at a concentration of, for example, 5 × 10¹⁵ cm⁻³.

Next, as shown in Fig. 15, an implantation step (S130) is performed. Specifically, an impurity of p type conductivity is implanted into breakdown voltage holding layer 122 using, as a mask, an oxide film formed through photolithography and etching, thereby forming p regions 123 as shown in Fig. 17. Further, after removing the oxide film thus used, an oxide film having a new pattern is formed through photolithography and etching. Using this oxide film as a mask, a conductive impurity of n type conductivity is implanted into predetermined regions to form n⁺ regions 124. In a similar way, a conductive impurity of p type conductivity is implanted to form p⁺ regions 125. As a result, the structure shown in Fig. 17 is obtained.

After such an implantation step, an activation annealing process is performed. This activation annealing process can be performed under conditions that, for example, argon gas is employed as atmospheric gas, heating temperature is set at 1700°C, and heating time is set at 30 minutes.

Next, a gate insulating film forming step (S 140) is performed as shown in Fig. 15. Specifically, as shown in Fig. 18, oxide film 126 is formed to cover breakdown voltage holding layer 122, p regions 123, n⁺ regions 124, and p⁺ regions 125. As a condition for forming oxide film 126, for example, dry oxidation (thermal oxidation) may be performed. The dry oxidation can be performed under conditions that the heating temperature is set at 1200°C and the heating time is set at 30 minutes.

Thereafter, a nitrogen annealing step (S150) is performed as shown in Fig. 15. Specifically, an annealing process is performed in atmospheric gas of nitrogen monoxide (NO). Temperature conditions for this annealing process are, for example, as follows: the heating temperature is 1100°C and the heating time is 120 minutes. As a result, nitrogen atoms are introduced into a vicinity of the interface between oxide film 126 and each of breakdown voltage holding layer 122, p regions 123, n⁺ regions 124, and p⁺ regions 125, which are disposed below oxide film 126. Further, after the annealing step using the atmospheric gas of nitrogen monoxide, additional annealing may be performed using argon (Ar) gas, which is an inert gas. Specifically, using the atmospheric gas of argon gas, the additional annealing may be performed under conditions that the heating temperature is set at 1100°C and the heating time is set at 60 minutes.

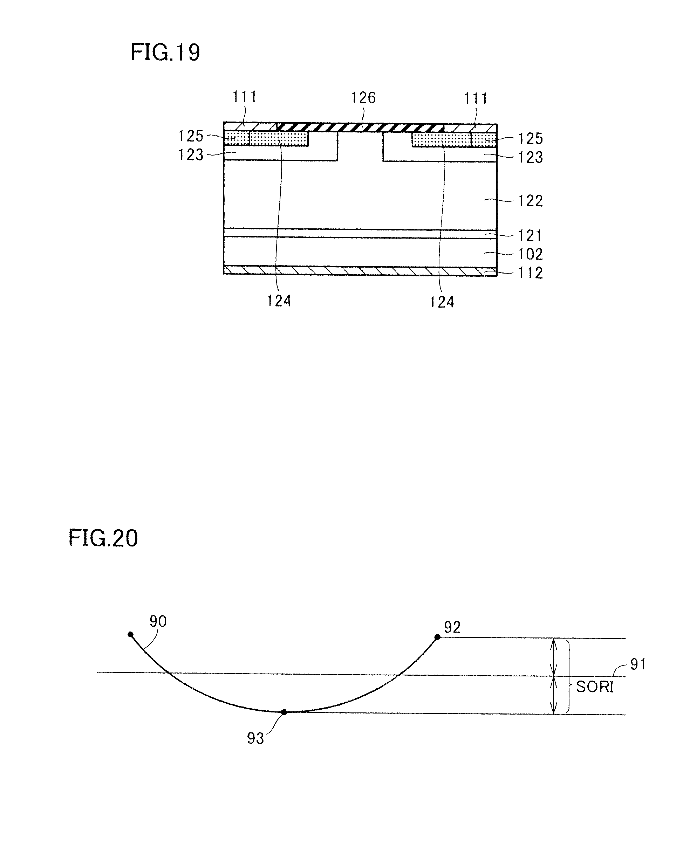

Next, as shown in Fig. 15, an electrode forming step (S160) is performed. Specifically, a resist film having a pattern is formed on oxide film 126 by means of the photolithography method. Using the resist film as a mask, portions of the oxide film above n⁺ regions 124 and p⁺ regions 125 are removed by etching. Thereafter, a conductive film such as a metal is formed on the resist film and formed in openings of oxide film 126 in contact with n⁺ regions 124 and p⁺ regions 125. Thereafter, the resist film is removed, thus removing the conductive film's portions located on the resist film (lift-off). Here, as the conductor, nickel (Ni) can be used, for example. As a result, as shown in Fig. 19, source electrodes 111 and drain electrode 112 can be obtained. It should be noted that on this occasion, heat treatment for alloying is preferably performed. Specifically, using atmospheric gas of argon (Ar) gas, which is an inert gas, the heat treatment (alloying treatment) is performed with the heating temperature being set at 950°C and the heating time being set at 2 minutes.

Thereafter, on source electrodes 111, upper source electrodes 127 (see Fig. 14) are formed. Further, drain electrode 112 (see Fig. 14) is formed on the backside surface of substrate 102. Further, gate electrode 110 (see Fig. 14) is formed on oxide film 126. In this way, semiconductor device 101 shown in Fig. 14 can be obtained. Namely, semiconductor device 101 is fabricated by forming the epitaxial layer and the electrodes on SiC layers 20 of silicon carbide substrate 1. Further, in the method for manufacturing semiconductor device 101 in the present embodiment, there is employed the silicon carbide substrate of the present invention which achieves restrained warpage even when a different-type material layer is formed on the substrate. Accordingly, exposure failure in for example step (S130) is restrained, thus manufacturing semiconductor devices 101 width high yield.

It should be noted that in the fifth embodiment, the vertical type MOSFET has been illustrated as one exemplary semiconductor device that can be fabricated using the silicon carbide substrate of the present invention, but the semiconductor device that can be fabricated is not limited to this. For example, various types of semiconductor devices can be fabricated using the silicon carbide substrate of the present invention, such as a JFET (Junction Field Effect Transistor), an IGBT (Insulated Gate Bipolar Transistor), and a Schottky barrier diode. Further, the fifth embodiment has illustrated a case where the semiconductor device is fabricated by forming the epitaxial layer, which serves as an active layer, on the silicon carbide substrate having its main surface corresponding to the (03-38) plane. However, the crystal plane that can be adopted for the main surface is not limited to this and any crystal plane suitable for the purpose of use and including the (0001) plane can be adopted for the main surface.

### [Example]

The following describes an example of the present invention. A different-type material layer was formed on the silicon carbide substrate of the present invention for an experiment to confirm the effect of restraining warpage by the silicon carbide substrate of the present invention.

Specifically, the silicon carbide substrate of the present invention was fabricated as follows. That is, 21 SiC substrates were arranged side by side on a base substrate and were connected thereto in accordance with the same method in the above-described first embodiment. The base substrate had a diameter of 2 inches, had a thickness of 400 µm. and was made of single-crystal silicon carbide. Each of the SiC substrates was made of single-crystal silicon carbide, had a square planar shape with each side of 10 mm. and had a thickness of 400 µm. On this occasion, a gap having a width of not less than 10 µm and not more than 100 µm is formed between the end surfaces of adjacent SiC substrates (example).

Meanwhile, for comparison, a silicon carbide substrate having a base substrate and a SiC substrate having the same planar shape as that of the base substrate and therefore falling out of the scope of the present invention was formed in accordance with the same method (comparative example). Further, as the different-type material layer, a W (tungsten) film having a thickness of 3 µm was deposited on the SiC substrate (SiC layer) of the silicon carbide substrate of each of the example and the comparative example. Warpage (SORI) of each of the silicon carbide substrates before the formation of the W film and warpage (SORI) thereof after the formation were measured. Here, referring to Fig. 20, a magnitude of warpage (SORI) is defined by a total value of a distance from a least squares plane 91 of main surface 90 of the substrate to a maximum point 92 of main surface 90 of the substrate and a distance therefrom to a minimum point 93. Hence, the value of warpage (SORI) is always a positive value.

**[Table 1]**

| | Before Formation of W Film | After Formation of W Film |
|---|---|---|
| Example | 5 µm | 20 µm |
| Comparative Example | 20 µm | 100 µm |

As shown in Table 1, the substrate of the example had a restrained warpage before the formation of the W film as compared with that of the substrate of the comparative example, and also had warpage restrained from being increased due to the formation of the W film. From this fact, it was confirmed that according to the silicon carbide substrate of the present invention, there can be provided a silicon carbide substrate achieving restrained warpage even when the different-type material layer is formed on the substrate.

The silicon carbide substrate of the present invention can be used to fabricate a semiconductor device as described above in the fifth embodiment. In other words, in the semiconductor device of the present invention, the epitaxial layer serving as an active layer is formed on the silicon carbide substrate of the present invention. More specifically, the semiconductor device of the present invention includes: the silicon carbide substrate of the present invention; the epitaxial layer formed on the silicon carbide substrate; and the electrodes formed on the epitaxial layer.

The embodiments and examples disclosed herein are illustrative and non-restrictive in any respect. The scope of the present invention is defined by the terms of the claims, rather than the embodiments described above, and is intended to include any modifications within the scope and meaning equivalent to the terms of the claims.

### INDUSTRIAL APPLICABILITY

The silicon carbide substrate of the present invention is particularly advantageously applicable to a silicon carbide substrate achieving restrained warpage in a process of manufacturing a semiconductor device.

### REFERENCE SIGNS LIST

1: silicon carbide substrate; 10: base layer (base substrate); 10A: main surface; 11: material substrate; 20: SiC layer (SiC substrate); 20A: main surface; 20B: end surface; 40: amorphous SiC layer; 41: Si layer; 60: gap; 70: intermediate layer; 71: precursor layer; 81: first heater; 82: second heater; 101: semiconductor device; 102: substrate; 110: gate electrode; 111: source electrode; 112: drain electrode; 121: buffer layer; 122: breakdown voltage holding layer; 123: p region; 124: n⁺ region; 125: p⁺ region; 126: oxide film; 127: upper source electrode.

## Claims

1. A silicon carbide substrate (1) comprising:
a base layer (10) made of silicon carbide; and
a plurality of SiC layers (20) arranged side by side on said base layer (10) when viewed in a planar view and each made of single-crystal silicon carbide,
a gap (60) being formed between adjacent SiC layers (20).

2. The silicon carbide substrate (1) according to claim 1, wherein said gap (60) has a width equal to or smaller than 1 mm.

3. The silicon carbide substrate (1) according to claim 1, wherein said gap (60) has a depth equal to or smaller than 2/3 of a thickness of said silicon carbide substrate (1).

4. The silicon carbide substrate (1) according to claim 1, wherein a plurality of said gaps (60) are formed.

5. The silicon carbide substrate (1) according to claim 4, wherein:
said plurality of gaps (60) include at least one pair of gaps (60) extending without intersecting with each other, and
an interval between said one pair of gaps (60) is 5 mm or greater.

6. The silicon carbide substrate (1) according to claim 4, wherein said plurality of gaps (60) include at least one pair of gaps (60) intersecting with each other.

7. The silicon carbide substrate (1) according to claim 6, wherein said plurality of gaps (60) are formed to intersect with one another in a form of lattice when viewed in a planar view.

8. The silicon carbide substrate (1) according to claim 1, wherein said base layer (10) has an impurity density greater than that of each of said SiC layers (20).

9. The silicon carbide substrate (1) according to claim 1, wherein said base layer (10) has an impurity density equal to or greater than 1 × 10¹⁸ atm/cm³.

10. The silicon carbide substrate (1) according to claim 1, wherein each of said SiC layers (20) has a main surface (20A) opposite to said base layer (10) and having an off angle of not less than 50° and not more than 65° relative to a {0001} plane.

11. The silicon carbide substrate (1) according to claim 10, wherein the main surface (20A) of each of said SiC layers (20) opposite to said base layer (10) has an off orientation forming an angle of 5° or smaller relative to a <1-100> direction.

12. The silicon carbide substrate (1) according to claim 11, wherein the main surface (20A) of each of said SiC layers (20) opposite to said base layer (10) has an off angle of not less than -3° and not more than 5° relative to a {03-38} plane in the <1 - 100> direction.

13. The silicon carbide substrate (1) according to claim 10, wherein the main surface (20A) of each of said SiC layers (20) opposite to said base layer (10) has an off orientation forming an angle of 5° or smaller relative to a <11-20> direction.

14. The silicon carbide substrate (1) according to claim 1, wherein a main surface (20A) of each of said SiC layers (20) opposite to said base layer (10) is polished.
